Europäisches Patentamt

European Patent Office

Office européen des brevets

(19)

(11) Veröffentlichungsnummer : **0 034 712**
**B1**

(12) **EUROPÄISCHE PATENTSCHRIFT**

(45) Veröffentlichungstag der Patentschrift :
08.02.84

(21) Anmeldenummer : 81100553.7

(22) Anmeldetag : 26.01.81

(51) Int. Cl.³ : **G 11 C   8/00**, G 11 C 11/40,
H 03 K 19/08

(54) Integrierte digitale Halbleiterschaltung.

(30) Priorität : 07.02.80 DE 3004565

(43) Veröffentlichungstag der Anmeldung :
02.09.81 Patentblatt 81/35

(45) Bekanntmachung des Hinweises auf die Patenterteilung : 08.02.84 Patentblatt 84/06

(84) Benannte Vertragsstaaten :
FR GB IT

(56) Entgegenhaltungen :
EP-A- 0 024 853
US-A- 3 736 573
US-A- 3 736 574
US-A- 4 005 393
US-A- 4 164 791
US-A- 4 168 490
IEEE JOURNAL OF SOLID-STATE CIRCUITS, Band
SC-13, Nr. 5, Oktober 1978, Selten 651-656 New York,
U.S.A. A. HOTTA et al.: "A high-speed low-power 4096
X 1 Bit Bipolar RAM"
SIEMENS FORSCHUNG- UND ENTWICKLUNGSBE-
RICHT, Band 6, Nr. 2, 1977, Selten 86-91 München,
DE. H. ERNST et al.: "A fast bipolar 1024-bit RAM for
high-performance memory systems"
IEEE JOURNAL OF SOLID-STATE CIRCUITS, Band
SC-9, Nr. 5, Oktober 1974, Selten 283-284 New York,
U.S.A. H. MAYUMI et al.: "A 25-ns read access bipolar
1 kblt TTL RAM"
IEEE TRANSACTIONS ON ELECTRON DEVICES,
Band ED-26, Nr. 6, Juni 1979, Selten 886-892 New
York, U.S.A. K. KAWARADA et al.: "A 4K-bit static 12L
memory"

(73) Patentinhaber : **SIEMENS AKTIENGESELLSCHAFT**
**Berlin und München Wittelsbacherplatz 2**
**D-8000 München 2 (DE)**

(72) Erfinder : **Rydval, Peter, Dipl.-Ing.**
**Hirtentäschelweg 11**
**D-8000 München 70 (DE)** ·

EP 0 034 712 B1

## Integrierte digitale Halbleiterschaltung

Die Erfindung betrifft eine integrierte digitale Halbleiterschaltung mit mehreren durch eine gemeinsame und durch einen Transistor gegebene Konstantstromquelle zu versorgenden n Anschlüssen, bei der der eine Betriebszustand jedes dieser Anschlüsse dem für alle diese Anschlüsse gleichen Pegel logisch « 0 » und der andere Betriebszustand dem für alle diese Anschlüsse gleichen Pegel logisch « 1 » entspricht, bei der außerdem der Aufbau und die Steuerung derart ausgebildet ist, daß sich während eines Betriebszustandes der Halbleiterschaltung alle diese Anschlüsse gemeinsam auf dem Pegel logisch « 0 » befinden, während den übrigen Betriebszuständen stets dieselbe Teilanzahl dieser Anschlüsse den Pegel logisch « 1 » und der Rest den Pegel logisch « 0 » erhält.

Solche Halbleiterschaltungen können z. B. als ROM-Speicher, als Dekoder oder als Encoder ausgebildet sein.

Als einschlägiger Stand der Technik ist hier die DE-C-24 30 784 zu nennen, in welcher ein den so eben aufgeführten Maßnahmen entsprechender bipolarer Halbleiterspeicher beschrieben ist. Die nach den dortigen Offenbarungen aufgebauten Umladungs-Schaltungsteile sind mittels Transistoren und Widerständen aufgebaut. Es lassen sich jedoch hier, wie gemäß der Erfindung erkannt wurde, die Transistoren der Umladungsschaltungen einsparen und die Umladungsschaltungen sich durch jeweils einen geeignet dimensionierten Widerstand ersetzen.

Demgemäß ist durch die Erfindung die Schaltung gemäß der obigen Definition dadurch gekennzeichnet, daß jeder dieser n Anschlüsse über je einen — die einzige Verbindung dieses Anschlusses mit der Konstantstromquelle (KQ) bildenden — Widerstand (R) mit dem Ausgang der Konstantstromquelle (KQ) verbunden ist und daß die einander gleichen und die genannte Verbindung bildenden Widerstände gemäß der Formel

$$R = U \cdot (n + k - 1)/I \cdot (k - 1)$$

eingestellt sind, in der U den zwischen dem Pegel logisch « 1 » und dem Pegel logisch « 0 » liegenden Spannungshub, k das Verhältnis des über den einzelnen Anschluß beim Pegel logisch « 1 » geführten Stromes zu dem beim Pegel logisch « 0 » über diesen Anschluß fließenden Strom und I den Wert des Gesamtstroms bedeutet, der im Falle der mit unterschiedlichen Pegeln an den besagten Anschlüssen verbunden Betriebszuständen der Halbleiterschaltung über die Gesamtheit dieser n Anschlüsse fließt.

Die beiden genannten Betriebszustände sind gemäß der eingangs gegebenen Definition einerseits dadurch bestimmt, daß die für Versorgung durch die Konstantstromquelle insgesamt vorgesehenen n Eingänge der digitalen Halbleiterschaltung den Pegel logisch « 0 » in dem einen Betriebszustand aufweisen, während sie andererseits in dem anderen Betriebszustand aufgrund der Konstruktion der Digitalschaltung in bekannter Weise derart geschaltet sind, daß gerade $n_1$ dieser n Eingänge den Pegel logisch « 1 » aufweisen und der Rest $(n - n_1)$ den Pegel logisch « 0 » hat. Dabei gilt ersichtlich $n > n_1$. Bei dem oben definierten integrierten statischen Schreib-Lese-Speicher ist $n_1 = 1$.

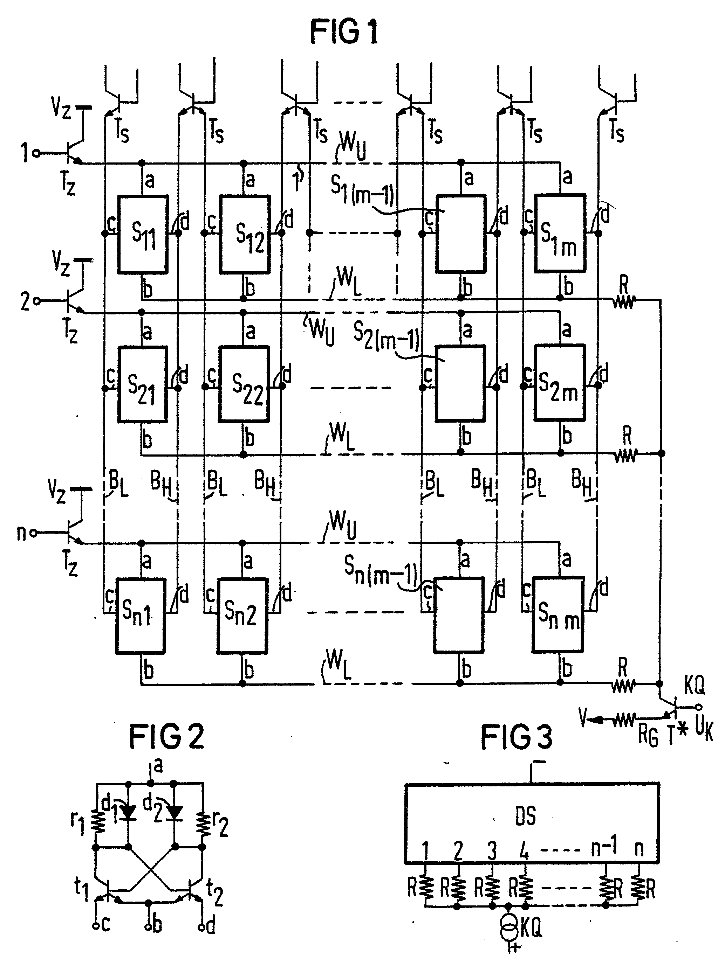

Auf diesen speziellen Fall wird dann anhand der Figuren 1 und 2 näher eingegangen. Vorerst soll noch auf den Stand der Technik kurz eingegangen werden.

Bei dem in der DE-C-24 30 784 beschriebenen bipolaren Halbleiterspeicher sind zwar die der eingangs gegebenen Definition entsprechenden Merkmale ebenfalls erfüllt. Jedoch ist dort anstelle der die Erfindung kennzeichnenden Merkmale vorgesehen, daß an die Matrix der Speicherzellen eine zusätzliche Umladeschaltung angeschlossen ist, in der jede Wortleitung der Speichermatrix über ein Koppelelement parallel an einen gemeinsamen Konstantstromgenerator angeschlossen ist. Dabei ist das Koppelelement derart ausgebildet, daß jeweils nur eine ausgewählte Zeile der Speichermatrix an ihrem Ausgang mit dem Konstantstromgenerator leitend verbunden ist. Die Schaltung für den bipolaren Halbleiterspeicher nach der DE-C-24 30 784 ist derart gestaltet, daß sie relativ stark voneinander abweichende Umlade- und Ruheströme für die einzelnen Speicherzellen benötigt. Um diesem Erfordernis gerecht zu werden, sind bei der bekannten Schaltung die jeweils durch einen Transistor und einem zwischen Basis und Kollektor dieses Transistors liegendem Widerstand gegebenen Koppelschaltungen vorgesehen. Bei der vorliegenden Erfindung hingegen ist hingegen lediglich ein entsprechend der Definition der Erfindung bemessener Widerstand R vorgesehen, der die Verbindung zwischen dem Ausgang der Stromquelle und dem durch die Stromquelle zu beaufschlagenden Eingang bildet, und der ausreicht, um die für die unterschiedlich großen Umlade- und Ruheströme benötigten Spannungsunterschiede zu erzeugen.

Weiterhin ist noch zu erwähnen, daß bei einer bipolaren Speicherschaltung nach der US-A-3 736 573 jede der unteren Zeilenleitungen über je einen Widerstand mit der Klemme für das Bezugspotential, aber nicht mit dem stromliefernden Ausgang einer Konstantstromquelle, verbunden ist. Außerdem sind dort die Speicherzellen so aufgebaut, daß die beiden Datenausgänge der Flip-Flop-Speicherzelle über je einen Widerstand (also ein lineares Element) an das Versorgungspotential gelegt sind und außer den beiden die Flip-Flop-Speicherzelle bildenden, kreuzgekoppelten bipolaren Transistoren keine weiteren nichtlinearen Elemente enthalten. Infolgedessen ist bei der Speicherschaltung nach der US-A-3 736 573 der gewünschte Strom durch die Speicherzellen ständig konstant, weshalb die Widerstände jeweils wie eine Stromquelle wirken.

Die Erfindung wird nun anhand der Figuren 1 bis 3 näher beschrieben, wobei zunächst auf den Fall $n_1 = 1$ eingegangen wird, der gemäß einer Speicherschaltung gemäß Figur 1 und 2 vorliegt. Die in Figur 3 dargestellte, verallgemeinerte Anlage wird erst später näher beschrieben.

Wie bereits angedeutet, beziehen sich die Fig. 1 und 2 auf die Anwendung der Erfindung auf einen monolithisch integrierten Halbleiterspeicher der genannten Art, der in Bipolartechnik ausgeführt ist. Dabei ist in Fig. 1 die Anschaltung der einzelnen Speicherzellen an die gemeinsame Konstantstromquelle und in Fig. 2 der — an sich bekannte — Aufbau der einzelnen Speicherzelle dargestellt.

Zu Fig. 2 dabei lediglich festzustellen, daß pro Speicherzelle (die in Fig. 1 mit $S_{11}$ bis $S_{nm}$ bezeichnet sind) zwei Bipolartransistoren $t_1$ und $t_2$ von npn-Typ mit jeweils zwei Emittern vorgesehen sind, die in üblicher Weise durch Verbindung ihrer Basis mit dem Kollektor des jeweiligen anderen Transistors sowie durch Verbindung ihrer Kollektoren über je einen Lastwiderstand $r_1$ bzw. $r_2$ mit einem gemeinsamen ersten Anschluß a sowie durch Verbindung je eines ihrer beiden Emitter mit einem gemeinsamen Anschluß b zu einer bistabilen Kippstufe zusammen geschaltet sind. Ergänzt ist diese Kippstufe durch zwei in Flußrichtung liegende Dioden $d_1$ und $d_2$, die in der aus Fig. 2 ersichtlichen Weise zur Überbrückung der beiden Lastwiderstände $r_1$ und $r_2$ dienen. Der andere Emitter des Transistors $t_1$ bildet den Steuereingang c, der andere Emitter des Transistors $t_2$ einen zweiten Steuereingang d der einzelnen Speicherzelle.

Die in Fig. 1 dargestellte und mit Hilfe der in Fig. 2 dargestellten Speicherzellen aufgebaute Speichermatrix hat n Zeilen und m Spalten. Die erste Zeile enthält demgemäß die Zellen $S_{11}$, $S_{12}$, ... $S_{1m}$, die zweite Zeile die Zellen $S_{21}$, ... $S_{2m}$ usw. und die letzte Zeile die Zellen $S_{n1}$ bis $S_{nm}$.

Oberhalb und unterhalb der Zellen der einzelnen Zeilen ist je eine zeilenparallel verlaufende Leitung vorgesehen, wobei die oberhalb der betreffenden Zeile verlaufende Leitung das Bezugszeichen $W_U$, die unterhalb der Zeile vorgesehene Leitung das Bezugszeichen $W_L$ führt. ($W_U$ = obere Wortleitung, $W_L$ = untere Wortleitung). In entsprechender Weise sind beiderseits der die einzelnen Spalten bildenden Speicherzellen je eine spaltenparallel verlaufende Leitung $B_H$ bzw. $B_L$ vorgesehen ($B_H$ = obere Bitleitung, $B_L$ = unter Bitleitung). Die den einzelnen Matrixzeilen jeweils zugeordnete Leitung $W_U$ ist unmittelbar mit dem Anschluß a aller die betreffende Matrixzeile bildenden Speicherzellen verbunden. In entsprechender Weise liegt der Anschluß b der die einzelne Matrixzeile bildenden Speicherzellen an dem der betreffenden Zeile jeweils zugeordneten Leiter $W_L$. Die Anschlüsse c der die einzelnen Matrixspalten bildenden Speicherzellen liegen an der betreffenden Spalte zugeordneten Leitung $B_L$ und die Anschlüsse d an der jeweils zugehörigen spaltenparallelen Leitung $B_H$.

Jede der Leitungen $W_U$ ist, wie aus Fig. 1 ersichtlich, mit dem Emitter je eines in Kollektorschaltung betriebenen Transistors $T_Z$ verbunden, dessen Basis einen der betreffenden Zeile jeweils zugeordneten und mit der Nummer der betreffenden Zeile bezeichneten Steuereingang bildet und dessen Kollektor an einem ersten der Versorgung der Matrix dienenden elektrischen Betriebspotential $V_Z$ liegt, das für alle Zeilen identisch ist.

Jede der spaltenparallelen Leitungen $B_H$ und $B_L$ ist der aus der Fig. 1 ersichtlichen Weise an einen Emitter von Transistoren $T_S$ gelegt, die ebenso wie die Transistoren $T_Z$, $T_1$ und $T_2$ als npn-Transistoren aufgebaut sind. Da die Anschaltung der einzelnen spaltenparallelen Leitungen $B_H$ und $B_L$ an die Transistoren $T_S$ sowie die Beaufschlagung der Transistoren $T_S$ in üblicher Weise erfolgt und für die Erfindung keine unmittelbare Bedeutung hat, soll auf diesbezügliche Einzelheiten nicht weiter eingegangen werden.

Gemäß der Erfindung ist nun jede der zeilenparallelen Leitungen $W_L$ über je einen Widerstand R an den Versorgungsausgang der gemeinsamen Konstantstromquelle KQ gelegt. Die Widerstände R sind gleich bemessen und sind entsprechend der Definition der Erfindung zu dimensionieren.

Vorab soll noch bemerkt werden, daß die den einzelnen Zeilen zugeordneten, zeilenparallelen Leitungspaare $W_U$ und $W_L$ die Wortleitung der betreffenden Zeile und die den einzelnen Spalten zugeordneten spaltenparallelen Leitungspaare $B_H$ und $B_L$ die der betreffenden Zeile zugeordneten Bitleitungen darstellen und dementsprechend zu beaufschlagen sind.

Die Konstantstromquelle KQ ist in dem aus der Fig. 1 ersichtlichen Beispielsfall durch einen npn-Transistor T* gegeben, dessen Kollektor über die einzelnen Widerstände R mit den einzelnen zeilenparallelen Leitungen $W_L$ und damit mit den Anschlüssen b aller Speicherzellen $S_{11}$ bis $S_{nm}$ verbunden ist, während seine Basis an einem aus den Betriebspotentialen der Gesamtschaltung abgeleiteten, insbesondere geregelten, Hilfspotential $U_K$ liegt. Der Emitter des die Konstantstromquelle bildenden Transistors T* liegt schließlich über einen Widerstand $R_G$ am zweiten Betriebspotential V der Schaltung.

Die Versorgungstransistoren $T_Z$ sind ersichtlich zugleich der Zeilenauswahl gewidmet und als Emitterfolger betrieben, wie dies auch bei den ihnen entsprechenden Transistoren bei den Speichern nach der DE-C-24 30 784 der Fall ist. Dabei spielt die Ladungskapazität der der Versorgung der einzelnen Speicherzellen dienenden zeilenparallelen Leitungen $W_U$ und $W_L$, also die Wortleitungskapazität, hinsichtlich der Schaltgeschwindigkeit eine merkliche Rolle, so daß im vorliegenden Fall, ebenso wie bei der bekannten Schaltung der Umladung dienende Maßnahmen getroffen sind. Im vorliegenden Fall sind deswegen die einander gleich dimensionierten Widerstände R vorgesehen. Dabei hängt die Dimensionierung von der für die einzelnen Schaltungen festgehaltenen Zahl $n_1$ sowie dem Stromfluß über die Konstantstromquelle KQ ab, was durch die in der Definition der Erfindung enthaltene Bemessungsformel für die einzelnen Widerstände R berücksichtigt ist.

Im Falle des in Fig. 1 dargestellten Matrixspeichers ist aufgrund der dort zu verwendenden Schaltungsweise $n_1 = 1$. Dementsprechend sind hier zwei Betriebszustände zu unterscheiden. Im ersten dieser Betriebszustände führen alle Wortleitungen und damit die Leitungen $W_U$, $W_L$ den Pegel logisch « 0 » und im zweiten Betriebszustand eine beliebige dieser Leitungen den Pegel « 1 » und die restlichen $(n - 1)$ Leitungen den Pegel « 0 ». In diesem Fall ist gemäß der Erfindung jeder der Widerstände R gemäß der Formel

$$R = U \cdot (n + k - 1)/I \cdot (k - 1) \qquad (1)$$

zu bemessen. Dabei ist U der Wortleitungshub, der durch die Differenz der an die einzelnen Wortleitungen zu legenden Auswahlspannung $U_A$ und der Ruhespannung $U_R$ gegeben ist. n bedeutet wiederum die Gesamtzahl der Zeilen der Speichermatrix und k das durch den Quotienten $k = I_A/I_R$ definierte Schaltverhältnis, wobei $I_A$ der Auswahlstrom und $I_R$ der über die einzelnen Wortleitungen geführte Ruhestrom ist. Der Gesamtstrom I berechnet sich aufgrund der Formel

$$I = I_R \cdot (n - 1) + I_A \cdot \qquad (2)$$

Diese stellt den über die Gesamtheit der n Wortleitungen fließenden Strom dar, wenn (was in der Regel der Fall ist) jeweils nur eine der n Wortleitungen $W_U$ und $W_L$ adressiert ist.

Anstelle eines Speichers kann die durch die Konstantstromquelle KQ zu beaufschlagende Digitalschaltung DS z. B. ein aus « 1 aus -Dekoder », ein Encoder oder eine sonstige Schaltung der eingangs definierten Art sein. Ist diese Schaltung DS so ausgelegt, daß höchstens nur einer der n vorgesehenen und durch die Konstantstromquelle zu beaufschlagenden Eingänge 1, 2, ... $(n - 1)$, n den Pegel logisch « 1 » haben kann, während alle restlichen Eingänge den Pegel « 0 » haben müssen, so liegen dieselben Verhältnisse vor, wie bei dem in Fig. 1 dargestellten Speicher. Die Bemessungsformeln (1) und (2) für die entsprechend Fig. 2 den einzelnen Wortleitungsteilen $W_L$ vorzuschaltenden Widerstände R können dann sinngemäß auch für die Bemessung der zwischen die einzelnen Eingänge 1 bis n und der gemeinsamen Konstantstromquelle KQ zu legenden Widerstände (vgl. Fig. 3) Anwendung finden, da die einzelnen Leitungen $W_L$ der Schaltung gemäß Fig. 1 den Eingängen 1 bis n der Verallgemeinerung gemäß Fig. 3 gleichzusetzen sind.

**Ansprüche**

1. Integrierte digitale Halbleiterschaltung mit mehreren durch eine gemeinsame und durch einen Transistor gegebene Konstantstromquelle zu versorgenden n Anschlüssen, bei der der eine Betriebszustand jedes dieser Anschlüsse dem für alle diese Anschlüsse gleichen Pegel logisch « 0 » und der andere Betriebszustand dem für alle diese Anschlüsse gleichen Pegel logisch « 1 » entspricht, bei der außerdem der Aufbau und die Steuerung derart ausgebildet ist, daß sich während eines Betriebszustandes der Halbleiterschaltung alle diese Anschlüsse gemeinsam auf dem Pegel logisch « 0 » befinden, während bei den übrigen Betriebszuständen stets dieselbe Teilanzahl dieser Anschlüsse den Pegel logisch « 1 » und der Rest den Pegel logisch « 0 » erhält, dadurch gekennzeichnet, daß jeder dieser n Anschlüsse über je einen — die einzige Verbindung dieses Anschlusses mit der Konstantstromquelle (KQ) bildenden — Widerstand (R) mit dem Ausgang der Konstantstromquelle (KQ) verbunden ist und daß die einander gleichen und die genannte Verbindung bildenden Widerstände gemäß der Formel

$$R = U \cdot (n + k - 1)/I \cdot (k - 1)$$

eingestellt sind, in der U den zwischen dem Pegel logisch « 1 » und dem Pegel logisch « 0 » liegenden Spannungshub, k das Verhältnis des über den einzelnen Anschluß beim Pegel logisch « 1 » geführten Stromes zu dem beim Pegel logisch « 0 » über diesen Anschluß fließenden Strom und I den Wert des Gesamtstroms bedeutet, der im Falle der mit unterschiedlichen Pegeln an den besagten Anschlüssen verbundenen Betriebszuständen der Halbleiterschaltung über die Gesamtheit dieser Anschlüsse fließt.

2. Halbleiterschaltung nach Anspruch 1, dadurch gekennzeichnet, daß im zweiten Betriebszustand lediglich jeweils einer der durch die Konstantstromquelle (KQ) zu beaufschlagenden Eingänge der digitalen Halbleiterschaltung auf den Pegel «1 » gehoben und der Rest auf den Pegel « 0 » gehalten ist.

3. Halbleiterschaltung nach Anspruch 2, dadurch gekennzeichnet, daß bei der als statischer Bipolarspeicher mit matrixförmig angeordneten Speicherzellen ($S_{11}$ bis $S_{nm}$) ausgebildeten digitalen Halbleiterschaltung (DS) den Speicherzellen jeder Matrixzeile eine gemeinsame Wortleitung ($W_U$, $W_L$) zugeordnet ist, die am einen Ende ($W_U$) mit dem Emitter je eines in Kollektorschaltung an ein erstes Betriebspotential ($V_Z$) liegenden Bipolartransistors ($T_Z$) verbunden und mit dem anderen Ende ($W_L$) über den genannten Widerstand (R) mit dem gemeinsamen Versorgungsausgang der ihrerseits durch das zweite Betriebspotential (V) beaufschlagten Konstantstromquelle (KQ) verbunden ist, an welchem auch die übrigen Wortleitungen durch je einen der gleich bemessenen Widerstände (R) gelegt sind.

4. Halbleiterschaltung nach Anspruch 2 oder 3, dadurch gekennzeichnet, daß die einzelnen

Speicherzellen ($S_{11}$, ... $S_{nm}$) unter Verwendung von npn-Bipolartransistoren ($t_1$ und $t_2$) unter Bildung einer bistabilen Kippstufe aufgebaut sind, daß die dabei verwendeteten Transistoren jeweils zwei Emitter aufweisen, von denen jeweils einer an die die Verbindung zur Konstantstromquelle (KQ) vermittelnde Teilleitung ($W_L$) der aus zwei über die einzelnen Speicherzellen der betreffenden Matrixzeile zusammenhängenden Teilleitungen ($W_U$, $W_L$) bestehenden Wortleitung gelegt ist, während der andere Emitter jeweils durch eine der beiden der die betreffende Speicherzelle enthaltenden Matrixspalte zugeordneten Bitleitungen ($B_H$ bzw. $B_L$) beaufschlagt ist, und daß schließlich die Kollektoren der beiden die jeweilige Speicherzelle bildenden Transistoren ($t_1$, $t_2$) über je eine Last an die andere Teilleitung ($W_U$) der zu der betreffenden Matrixzeile gehörenden Wortleitung ($W_U$, $W_L$) gelegt sind.

## Claims

1. An integrated digital semiconductor circuit having a plurality of terminals, 1 to n, which are to be supplied by a transistor forming a common constant current source, wherein the first operating state of each of these terminals corresponds to the logic « 0 » level which is identical for all these terminals, whereas the other operating state corresponds to the logic « 1 » level which is identical for all these terminals, wherein moreover the construction and the control are contrived to be such that during one operating state of the semiconductor circuit all these terminals are commonly connected to the logic « 0 » level whereas in the other operating states always the same sub-number of these terminals carry the logic « 1 » level and the remainder carry the logic « 0 » level, characterised in that each of these n terminals is connected to the output of the constant current source (KQ) via a resistor (R) which forms the sole connection between this terminal and the constant current source (KQ), and that the resistors which form the aforementioned connection are identical to one another and are set in accordance with the formula

$$R = U \cdot (n + k - 1)/I \cdot (k - 1)$$

in which U represents the voltage change between the logic « 1 » level and the logic « 0 » level, k represents the ratio of the current which flows via an individual terminal at the logic « 1 » level to the current which flows via this terminal at the logic « 0 » level, and I represents the value of the overall current which flows across the totality of these terminals in the operating states of the semiconductor circuit which are connected to the aforementioned terminals with different levels.

2. A semiconductor circuit as claimed in Claim 1, characterised in that in the second operating state only one of the inputs of the digital semiconductor circuit supplied by the constant current source (KQ) is raised to the level « 1 » whereas the remainder retain the level « 0 ».

3. A semiconductor circuit as claimed in Claim 2, characterised in that the digital semiconductor circuit (DS) is designed as a static bipolar store in which the storage cells ($S_{11}$ to $S_{nm}$) are arranged in a matrix formation, the storage cells of each matrix row are assigned a common word line ($W_U$, $W_L$) connected at one end via the emitter of a bipolar transistor ($T_Z$) common collector stage to a first operating potentials ($V_Z$) and at the other end ($W_L$) via the aforementioned resistor (R) to the common supply output of the constant current source (KQ), which is itself supplied by the second operating potential (V), which supply output is connected to each of the word lines by one of the identically constructed resistors (R).

4. A semiconductor circuit as claimed in Claim 2 or 3, characterised in that the individual storage cells ($S_{11} ... S_{nm}$) are constructed by npn-bipolar transistors ($t_1$ and $t_2$) forming bistable trigger stages, that the transistors used each possess two emitters, one of which is connected to that sub-line ($W_L$) establishing the connection to the constant current source (KQ) of a word line consisting of two sub-lines ($W_U$, $W_L$) interconnected via the individual storage cells of the matrix row in question, whereas the other emitter is supplied by one of the two bit lines ($B_H$ and $B_L$) which are assigned to the matrix row which contains the storage cell in question, and that finally the collectors of the two transistors ($t_1$, $t_2$) which form the storage cell in question are each connected via a load to the other sub-line ($W_U$) of the word line ($W_U$, $W_L$) which is assigned to the matrix row in question.

## Revendications

1. Circuit numérique intégré à semiconducteurs avec plusieurs n bornes à alimenter par une source de courant constant commune, constituée par un transistor, du type dans lequel l'un des états de fonctionnement de chacune de ces bornes correspond au même niveau logique « 0 » pour toutes ces bornes et l'autre état de fonctionnement correspond au même niveau logique « 1 » pour toutes ces bornes, dans lequel, en outre, la constitution et la commande sont réalisées de telle manière que pendant l'un des états de fonctionnement du circuit à semiconducteurs toutes ces bornes se trouvent en commun au niveau logique « 0 », alors que pendant les autres états de fonctionnement, toujours le même nombre partiel de ces bornes reçoivent le niveau logique « 1 » et le restant le niveau logique « 0 », caractérisé par le fait que chacune de ces n bornes est reliée à la sortie de la source de courant constant (KQ) par une résistance respective (R) qui forme la seule liaison de cette borne avec la source de courant constant (KQ), et que les résistances identiques et qui forment ladite liaison sont ajustées selon la relation

$$R = U \cdot (n + k - 1)/I \cdot (k - 1)$$

dans laquelle U désigne l'excursion de la tension qui se situe entre le niveau logique « 1 » et le niveau logique « 0 », k désigne le rapport entre le courant passant par une borne individuelle dans le cas du niveau logique « 1 » et le courant passant par cette borne dans le cas du niveau logique « 0 », et I désigne la valeur du courant total passant par l'ensemble de ces n bornes, dans le cas des états de fonctionnement du circuit à semiconducteurs liés auxdites bornes avec des niveaux différents.

2. Circuit à semiconducteurs selon la revendication 1, caractérisé par le fait que dans le second état de fonctionnement, uniquement l'une des entrées du circuit numérique à semiconducteurs qui est à relier à la source de courant constant (KQ) est élevée au niveau « 1 » et le restant est maintenu au niveau « 0 ».

3. Circuit à semiconducteurs selon la revendication 2, caractérisé par le fait que dans le cas du circuit numérique à semiconducteurs (DS) réalisé sous la forme d'une mémoire bipolaire statique à cellules de mémoire ($S_{11}$ à $S_{nm}$) disposées selon une matrice, on associe aux cellules de mémoire de chaque ligne de la matrice un conducteur de mots commun ($W_U$, $W_L$) qui, à une extrémité ($W_U$), est relié à l'émetteur d'un transistor bipolaire ($T_Z$) à collecteur commun auquel est appliqué un premier potentiel de fonctionnement ($W_Z$), et dont l'autre extrémité ($W_L$) est reliée, par l'intermédiaire de ladite résistance (R), à la sortie d'alimentation commune de la source de courant constant (KQ) chargée à son tour par le second potentiel de fonctionnement (V) auquel sont également portés les autres conducteurs de mots par l'intermédiaire des résistances (R) respectives de valeurs identiques.

4. Circuit à semiconducteurs selon la revendication 2 ou 3, caractérisé par le fait que les différentes cellules de mémoire ($S_{11}$ ... $S_{nm}$) sont constituées avec mise en œuvre de transistors bipolaires npn ($t_1$ et $t_2$) en formant un étage à bascule bistable, que les transistors utilisés à cet effet comportent deux émetteurs dont l'un est relié au conducteur partiel du conducteur de mot ($W_L$), fournissant la liaison avec la source de courant constant (KQ), et constitué par deux conducteurs partiels ($W_U$, $W_L$) reliés par l'intermédiaire des différentes cellules de mémoire de la ligne de matrice correspondante, alors que l'autre émetteur est relié par l'un des deux conducteurs de bits ($B_H$, $B_L$) associés à la colonne de la matrice qui contient la cellule de mémoire concernée, et que finalement les collecteurs des deux transistors ($t_1$, $t_2$) qui forment la cellule de mémoire, sont reliés, par l'intermédiaire d'une charge, à l'autre conducteur partiel ($W_U$) de la ligne de mot ($W_U$, $W_L$) qui appartient à la ligne concernée de la matrice.

## FIG 1

## FIG 2

## FIG 3